(19) Europäisches Patentamt
European Patent Office
Office européen des brevets

(11) **EP 4 708 425 A1**

(12) **EUROPEAN PATENT APPLICATION**

(43) Date of publication:
**11.03.2026 Bulletin 2026/11**

(21) Application number: **25189896.1**

(22) Date of filing: **16.07.2025**

(51) International Patent Classification (IPC):
**H01M 10/052** (2010.01)    **H01M 10/058** (2010.01)
**H01M 10/48** (2006.01)    **H01M 10/44** (2006.01)
**H01M 4/02** (2006.01)

(52) Cooperative Patent Classification (CPC):
**H01M 10/446; H01M 10/052; H01M 10/058;
H01M 10/48;** H01M 2004/021; H01M 2004/027

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **06.09.2024 JP 2024154178**

(71) Applicant: **Prime Planet Energy & Solutions, Inc.
Chuo-ku, Tokyo 103-0022 (JP)**

(72) Inventors:
• **SADAKANE, Takayuki
Tokyo, 103-0022 (JP)**
• **KAMIYAMA, Yuma
Tokyo, 103-0022 (JP)**

(74) Representative: **Kuhnen & Wacker
Patent- und Rechtsanwaltsbüro PartG mbB
Prinz-Ludwig-Straße 40A
85354 Freising (DE)**

(54) **MANUFACTURING METHOD OF NONAQUEOUS ELECTROLYTE SECONDARY BATTERY**

(57)    The manufacturing method of the nonaqueous electrolyte secondary battery is provided, which includes a construction step for constructing a secondary battery whose volume is equal to or more than at least 500 cm$^3$, an initial electrically charging step for electrically charging the secondary battery until a SOC becomes 20% to 39%, a high temperature aging step for heating up and holding the secondary battery in a high temperature range, a room temperature aging step for cooling down the secondary battery being in the high temperature range and then holding the secondary battery in a room temperature range, and an inspecting resistance step for calculating an internal resistance of the secondary battery while the secondary battery is maintained in the room temperature range.

FIG.1

**Description**

BACKGROUND

1. Technical Field

A present disclosure relates to a manufacturing method of a nonaqueous electrolyte secondary battery.

2. Background

In general, regarding a manufacturing step of a nonaqueous electrolyte secondary battery, such as lithium ion secondary battery, it is general to include a step for inspecting a performance of the battery. As conventional technique cited documents relating to the manufacturing method of the nonaqueous electrolyte secondary battery, it is possible to refer Japanese Patent Application Publication No. 2014-225368, and Japanese Patent Application Publication No. 2013-152849.

Japanese Patent Application Publication No. 2014-225368 and Japanese Patent Application Publication No. 2013-152849 disclose inspection methods in which an internal resistance of the battery is derived before and after an aging step for formation of a SEI coating layer performed after an initial electric charge, and in which whether the battery performance is good or bad is determined on the basis of this result.

In order to suitably generate the SEI coating layer for enhancing the battery performance, it is required to pay attention to a value of a SOC after an end of the initial electrically charging step. From a perspective of suitably forming the SEI coating layer, it is preferable to perform the aging in a state where the electrical charge is performed until a high SOC is reached. However, in a situation where the electrical charge is performed until the high SOC is reached, it takes long time for the electrical charge, so as to cause a delay on a manufacturing step.

On the other hand, for deriving the internal resistance, it is general to use a value of an electrical discharge voltage, and thus it is required to energize the secondary battery when the internal resistance is derived. The secondary battery heats up due to an effect of Joule heat when the battery is energized, and thus this energizing could cause reduction in calculation precision for the internal resistance.

As described above, regarding the manufacture of the secondary battery, it might be said that providing a high quality secondary battery is difficult without causing the delay on the manufacturing step but with precisely measuring the internal resistance.

SUMMARY

In order to solve the problem described above, the manufacturing method of the nonaqueous electrolyte secondary battery disclosed herein includes an constructing step for constructing the secondary battery whose volume is equal to or more than at least 500 cm$^3$, an initial electrically charging step for electrically charging the secondary battery until a SOC becomes 20% to 39%, a high temperature aging step for heating up and holding the secondary battery in a high temperature range, a room temperature aging step for cooling down the secondary battery being in the high temperature range and then holding the secondary battery in a room temperature range, and a inspecting resistance step for calculating an internal resistance of the secondary battery while the secondary battery is maintained in the room temperature range.

BRIEF DESCRIPTION OF THE DRAWINGS

FIG. 1 is a flowchart that is for explaining a manufacturing step in accordance with one embodiment.
FIG. 2 is a perspective view that schematically shows a nonaqueous electrolyte secondary battery in accordance with one embodiment.
FIG. 3 is a longitudinal cross section view that is schematically shown along an II-II line of FIG. 2.
FIG. 4 is a perspective view that schematically shows an electrode assembly group 20 attached to a sealing plate 14.
FIG. 5 is a perspective view that schematically shows an electrode assembly 20a.
FIG. 6 is a schematic view that shows a configuration of the electrode assembly.
FIG. 7 is a flowchart that is for explaining the manufacturing step in accordance with one embodiment.
FIG. 8 is a graph that shows a time dependence of a temperature of the nonaqueous electrolyte secondary battery in accordance with one embodiment after an electrically charging and discharging step.

DETAILED DESCRIPTION

Below, a preferred embodiment of a herein disclosed technique would be explained. Incidentally, the matters other than matters particularly mentioned in this specification, which are matters required for implementing the herein disclosed technique, can be grasped as design matters of those skilled in the art based on the related art in the present field. The herein disclosed technique can be executed based on the contents disclosed in the present specification, and based on the technical common sense in the present field. Additionally, in drawings explained by the present specification, the members/parts providing the same effect might be provided with the same numerals and signs so as to be explained, and an overlapping explanation might be omitted or simplified. Additionally, a dimensional relation (a length, a width, a thickness, or the like) in each drawing does not always reflect the actual dimensional relation.

A term "secondary battery" in the present specification is a term denoting a general electricity storage device that is capable of repeating an electrical charge and an electrical discharge in response to a movement of a charge carrier between a positive electrode and a negative electrode, and represents a concept semantically covering a so-called storage battery (a chemical battery), such as lithium ion secondary battery and sodium ion secondary battery, and semantically covering a capacitor (a physical battery), such as lithium ion capacitor (LIC). Below, each of main configuration materials of the secondary battery in accordance with the present disclosure would be explained. Incidentally, as for configuration materials of the secondary battery which are not described here, conventionally known ones can be used.

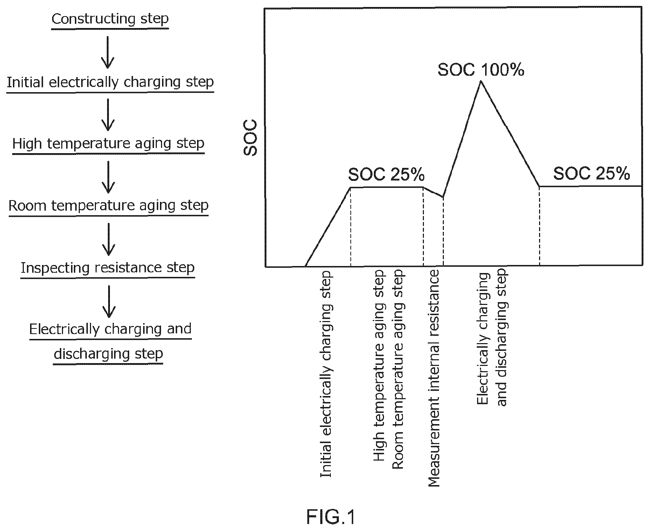

FIG. 1 is a flowchart that is for explaining a manufacturing step in accordance with one embodiment. Below, each step would be explained in order.

1. Constructing step

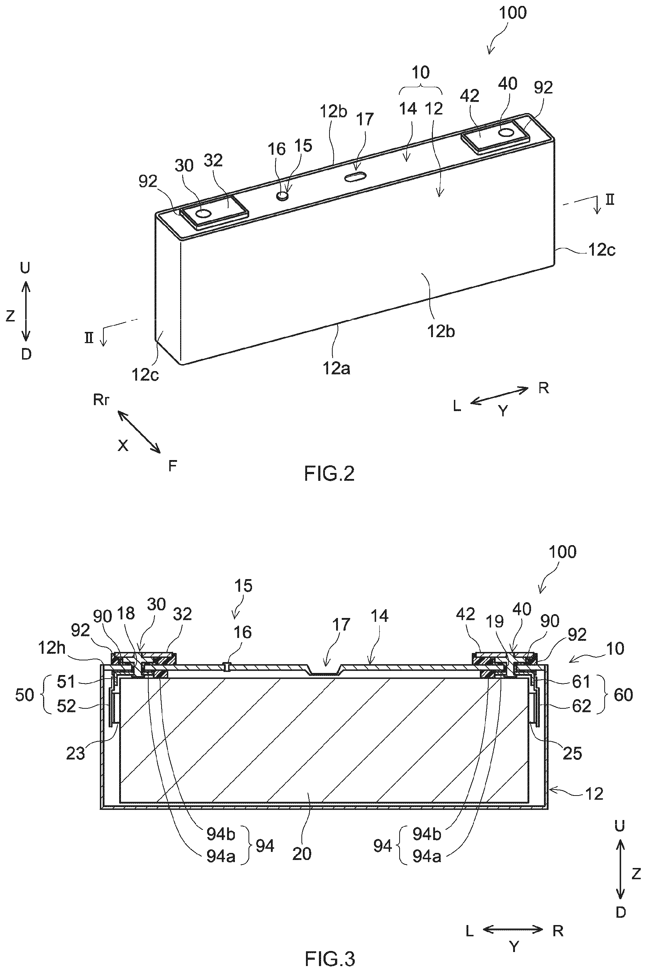

At a constructing step, the secondary battery is constructed. FIG. 2 is a perspective view that schematically shows the nonaqueous electrolyte secondary battery in accordance with one embodiment. FIG. 3 is a longitudinal cross section view that is schematically shown along an II-II line of FIG. 2.

1.1 Secondary battery

The term "secondary battery" in the present specification is the term denoting a general electricity storage device that is capable of repeating the electrical charge and the electrical discharge in response to the movement of the charge carrier between the positive electrode and the negative electrode, and represents the concept semantically covering the so-called storage battery (the chemical battery), such as lithium ion secondary battery and sodium ion secondary battery, and semantically covering the capacitor (the physical battery), such as lithium ion capacitor (LIC). Below, each of the main configuration materials of the secondary battery in accordance with the present disclosure would be explained. Incidentally, as for configuration materials of the secondary battery which are not described here, conventionally known ones can be used.

In an explanation described below, reference signs L, R, F, Rr, U, and D of drawings respectively represent left, right, front, rear, up, and down, and reference signs X, Y, and Z of drawings respectively represent a short side direction (a thickness direction), a long side direction (a width direction) orthogonal to the short side direction, and a vertical direction (a height direction) of the nonaqueous electrolyte secondary battery 100. However, these are merely directions for convenience sake of explanation, which never restrict the disposed form of the nonaqueous electrolyte secondary battery 100.

As shown in FIG. 3, the nonaqueous electrolyte secondary battery 100 includes a battery case 10, an electrode assembly group 20, a positive electrode terminal 30, a negative electrode terminal 40, a positive electrode current collector part 50, and a negative electrode current collector part 60. As the illustration is omitted, the nonaqueous electrolyte secondary battery 100 herein further includes a nonaqueous electrolytic solution. The nonaqueous electrolyte secondary battery 100 herein is a lithium ion secondary battery.

The battery case 10 is a housing that is configured to accommodate the electrode assembly group 20. The battery case 10 has an outer appearance that is formed in a flat and bottomed rectangular parallelopiped shape (a square shape). A material of the battery case 10 might be the same as a material conventionally used, and is not particularly restricted. It is preferable that the battery case 10 is made of metal, and it is further preferable that, for example, the battery case is made of aluminum, aluminum alloy, iron, iron alloy, or the like. As shown in FIG. 3, the battery case 10 includes an outer package 12 configured to include an opening 12h and includes a sealing plate (a lid body) 14 configured to cover the opening 12h.

The outer package 12 includes, as shown in FIG. 2, a bottom wall 12a, a pair of longer side walls 12b that extend from the bottom wall 12a and are opposed mutually, and a pair of shorter side walls 12c that extend from the bottom wall 12a and are opposed mutually. The bottom wall 12a is formed in an approximately rectangular shape. The bottom wall 12a is opposed to the opening 12h. An area size of the shorter side wall 12c is smaller than an area size of the longer side wall 12b.

The longer side wall 12b and the shorter side wall 12c are respectively examples of the first side wall and the second side wall disclosed herein. In the present embodiment, a direction in which the longer side walls 12b are opposed is the thickness direction of the battery. The sealing plate 14 is attached to the outer package 12 to cover the opening 12h of the outer package 12. The sealing plate 14 is opposed to the bottom wall 12a of the outer package 12. The sealing plate 14 is approximately rectangular in a plane view. The battery case 10 is integrated by joining (for example, welding and joining) the sealing plate 14 to a peripheral edge of the opening 12h of the outer package 12. The battery case 10 is airtightly sealed (hermetically sealed).

As shown in FIG. 3, the sealing plate 14 is provided with a liquid injection hole 15, a gas exhaust valve 17, and 2 terminal taking-out holes 18, 19. The liquid injection hole 15 is for injecting the electrolytic solution after the sealing plate 14 is assembled to the outer package 12. The liquid injection hole 15 is sealed by a sealing member 16. The gas exhaust valve 17 is configured to be broken when a pressure inside the battery case 10 becomes equal to or more than a predetermined value, so as to exhaust the gas inside the battery case 10 to the outside. The terminal taking-out holes 18, 19 are respectively formed at both ends of the sealing plate 14 in the long side direction Y. The terminal taking-out holes 18, 19 penetrate the sealing plate 14 in a vertical direction Z. The terminal taking-out holes 18, 19 respectively have inner diameters whose sizes can allow the positive electrode terminal 30 and the negative electrode terminal 40, before attached to the sealing plate 14 (before a crimping process), to be inserted into.

The positive electrode terminal 30 and the negative electrode terminal 40 both are fixed to the sealing plate 14. The positive electrode terminal 30 is arranged at one side (at a left side of FIG. 2 and FIG. 3) in the long side direction Y of the sealing plate 14. The negative electrode terminal 40 is arranged at the other side (at a right side of FIG. 2 and FIG. 3) in the long side direction Y of the sealing plate 14. As shown in FIG. 2, the positive electrode terminal 30 and the negative electrode terminal 40 are exposed to a surface at an outer side of the sealing plate 14. As shown in FIG. 3, the positive electrode terminal 30 and the negative electrode terminal 40 are respectively inserted into the terminal taking-out holes 18, 19 and extend from an inside to an outside of the sealing plate 14. The positive electrode terminal 30 and the negative electrode terminal 40 herein are crimped by the crimping process respectively at peripheral edge parts surrounding the terminal taking-out holes 18, 19 of the sealing plate 14. On end parts (top end parts of FIG. 3) at the outer package 12 sides of the positive electrode terminal 30 and the negative electrode terminal 40, crimping parts are formed.

As shown in FIG. 3, the positive electrode terminal 30 is electrically connected to a positive electrode tab group 23 of the electrode assembly group 20 through the positive electrode current collector part 50 at the inside of the outer package 12. The negative electrode terminal 40 is electrically connected to the negative electrode tab group 25 of the electrode assembly group 20 through the negative electrode current collector part 60 at the inside of the outer package 12. The positive electrode terminal 30 and the negative electrode terminal 40 are examples of the herein disclosed terminal.

It is preferable that the positive electrode terminal 30 is made of metal, and it is further preferable that the positive electrode terminal is made of, for example, aluminum or aluminum alloy. It is preferable that the negative electrode terminal 40 is made of metal, and it is further preferable that the negative electrode terminal is made of, for example, copper or copper alloy. The negative electrode terminal 40 might be configured by joining two conductive members to be integrated. For example, a portion connected to the negative electrode current collector part 60 might be made of copper or copper alloy, and a portion exposed on the outside surface of the sealing plate 14 might be made of aluminum or aluminum alloy.

As shown in FIG. 2, on the surface at the outer side of the sealing plate 14, a positive electrode outside conductive member 32 and a negative electrode outside conductive member 42, which are formed in plate shapes, are attached. The positive electrode outside conductive member 32 is electrically connected to the positive electrode terminal 30. The negative electrode outside conductive member 42 is electrically connected to the negative electrode terminal 40. The positive electrode outside conductive member 32 and the negative electrode outside conductive member 42 are members to which a bus bar is attached when plural nonaqueous electrolyte secondary batteries 100 are mutually connected in an electrical manner. It is preferable that the positive electrode outside conductive member 32 and the negative electrode outside conductive member 42 are made of metal, and it is further preferable that they are made of, for example, aluminum or aluminum alloy. The positive electrode outside conductive member 32 and the negative electrode outside conductive member 42 are insulated from the sealing plate 14 by an outside insulating member 92. However, the positive electrode outside conductive member 32 and the negative electrode outside conductive member 42 are not essential, and might be omitted in another embodiment.

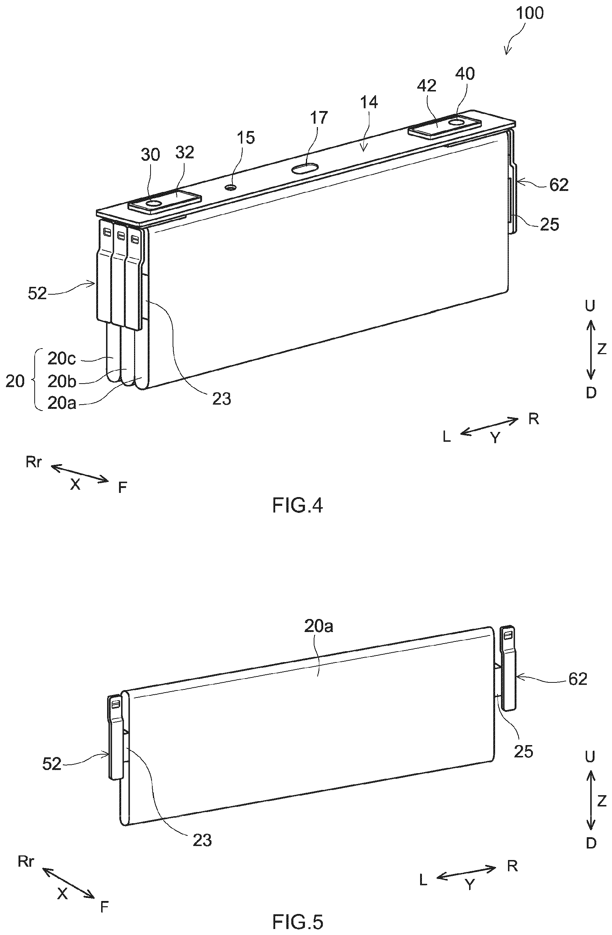

FIG. 4 is a perspective view that schematically shows the electrode assembly group 20 attached to the sealing plate 14. FIG. 5 is a perspective view that schematically shows an electrode assembly 20a. Regarding the nonaqueous electrolyte secondary battery 100 in accordance with the present embodiment, the electrode assembly group 20 including plural electrode assemblies 20a, 20b, 20c at the inside is accommodated by the battery case 10. However, a number of the electrode assemblies arranged at the inside of one outer package 12 is not particularly restricted, and the number might be 2 or more (plural) or might be 1. Although detailed structure would be described later, each of the electrode assemblies 20a, 20b, 20c includes the positive electrode tab group 23 configured with plural positive electrode tabs 22t and includes the negative electrode tab group 25 configured with plural negative electrode tabs 24t. The positive electrode current collector part 50 configures a conduction path that electrically connects the positive electrode tab group 23 and the positive electrode terminal 30. In addition, the negative electrode current collector part 60 configures a conduction path that electrically connects the negative electrode tab group 25 and the negative electrode terminal 40. Here, one of end parts of the electrode assembly 20a is provided with the positive electrode tab group 23 and the other one of the end parts is provided with the negative electrode tab group 25.

As shown in FIG. 3, the positive electrode current collector part 50 includes a positive electrode first current collector part 51 that is a plate-shaped conductive member extending along an inner side surface of the sealing plate 14 and includes a positive electrode second current collector part 52 that is a plate-shaped conductive member extending along the vertical direction Z. A lower end part of the positive electrode terminal 30 is configured to pass through the terminal taking-out hole 18 of the sealing plate 14 and to extend toward the inside of the battery case 10, so as to be connected to the positive electrode first current collector part 51 (see FIG. 3). On the other hand, as shown in FIG. 3, the positive electrode second current collector part 52 has one end that is connected to the positive electrode first current collector part 51 and has the other end that is connected to the positive electrode tab group 23 of the electrode assembly group 20. Here, the positive electrode tab group 23 of the electrode assembly group 20 is folded and bent to make the positive electrode second current collector part 52 and the side surfaces provided with the positive electrode tab groups 23 of the electrode assemblies 20a, 20b, 20c be opposed to each other. By this, it is possible to narrow a width of the positive electrode tab group 23 in the long side direction Y. As the result, it is possible to increase a coating width in the long side direction Y of the positive electrode active material layer 22a and the negative electrode active material layer 24a included by the electrode assembly group 20 as described later, and thus it is possible to implement making the nonaqueous electrolyte secondary battery 100 have a higher capacity. Incidentally, it is preferable that the positive electrode first current collector part 51 and the positive electrode second current collector part 52 are made of metal, and they are, for example, configured with an aluminum, an aluminum alloy, a nickel, a stainless steel, or the like.

As shown in FIG. 3, the negative electrode current collector part 60 includes a negative electrode first current collector part 61 that is a conductive member formed in a plate shape extending along an inner side surface of the sealing plate 14, and includes a negative electrode second current collector part 62 that is a conductive member formed in a plate shape extending along the vertical direction Z. A lower end part of the negative electrode terminal 40 passes through the terminal taking-out hole 19 of the sealing plate 14 to extend toward an inside of the battery case 10, so as to be connected to the negative electrode first current collector part 61 (see FIG. 3). On the other hand, as shown in FIG. 3, the negative electrode second current collector part 62 has one end connected to the negative electrode first current collector part 61, and has the other end connected to the negative electrode tab group 25 of the electrode assembly group 20. Here, the negative electrode tab group 25 of the electrode assembly group 20 is folded and bent to make the negative electrode second current collector part 62 and the side surfaces including the negative electrode tab groups 25 of the electrode assemblies 20a, 20b, 20c be opposed to each other. By this, similarly to a configuration in which the above described positive electrode tab group 23 is folded and bent, it is possible to implement making the nonaqueous electrolyte secondary battery 100 have the higher capacity. Incidentally, it is preferable that the negative electrode first current collector part 61 and the negative electrode second current collector part 62 are made of metal, and they are, for example, configured with a copper, a copper alloy, a nickel, a stainless steel, or the like.

Regarding the nonaqueous electrolyte secondary battery 100 in accordance with the present embodiment, in order to inhibit the continuity between arbitrary members, various insulating members are attached between these members.

Between the battery case 10 and the electrode assembly group 20, the insulating member for inhibiting the continuity is attached. In particular, between the positive electrode outside conductive member 32 (or the negative electrode outside conductive member 42) and an outer side surface of the sealing plate 14, there is an outside insulating member 92 (see FIG. 3). By this, it is possible to inhibit the positive electrode outside conductive member 32 or the negative electrode outside conductive member 42 from conducting with the sealing plate 14.

On each of the terminal taking-out holes 18, 19 of the sealing plate 14, a gasket 90 is installed. By this, it is possible to inhibit the positive electrode terminal 30 (or the negative electrode terminal 40) inserted into the terminal taking-out hole 18, 19 from conducting with the sealing plate 14.

Between the positive electrode first current collector part 51 (or the negative electrode first current collector part 61) and an inner side surface of the sealing plate 14, an inside insulating member 94 is arranged. This inside insulating member 94 includes a base part 94a that is formed in a plate shape and that is positioned between the positive electrode first current collector part 51 (or the negative electrode first current collector part 61) and the inner side surface of the sealing plate 14. By this, it is possible to inhibit the positive electrode first current collector part 51 or the negative electrode first current collector part 61 from conducting with the sealing plate 14. Further, the inside insulating member 94 includes a protruding part 94b that protrudes from the inner side surface of the sealing plate 14 toward the electrode assembly group 20. By this, it is possible to restrict a movement of the electrode assembly group 20 in the vertical direction Z and to inhibit the electrode assembly group 20 and the sealing plate 14 from directly coming into contact with each other.

A material of each insulating member described above is not particularly restricted, if it has a predetermined insulating property. As an example, it is possible to use a synthetic resin material, such as polyolefin base resin (example:

polypropylene (PP), polyethylene (PE)), fluorine base resin (example: perfluoro alkoxy alkane (PFA), polytetrafluoroethylene (PTFE)), or the like.

### 1.2 Electrode assembly

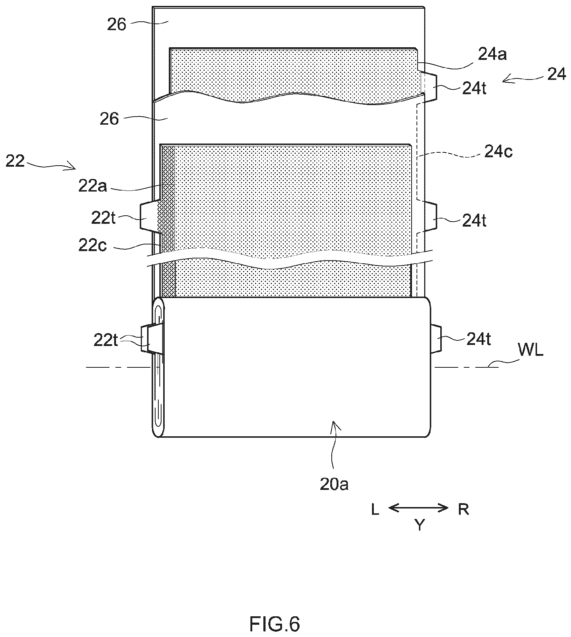

FIG. 6 is a schematic view that shows a configuration of the electrode assembly. The electrode assembly 20 is a power generating element of the nonaqueous electrolyte secondary battery 100. As shown in FIG. 6, the electrode assembly 20 includes the positive electrode 22, the negative electrode 24, and the separator 26. Incidentally, the electrode assembly 20 shown by FIG. 6 is a wound electrode assembly. This wound electrode assembly is manufactured by laminating the positive electrode 22, the negative electrode 24, and the separator 26 so as to form a laminate body having a long strip-like shape, and by winding this laminate body about the winding axis WL treated as a center. However, a structure of the electrode assembly 20 is not particularly restricted, and it might be another conventionally known structure (laminate electrode assembly, or the like).

The positive electrode 22 includes, as shown in FIG. 6, a positive electrode substrate 22c, and the positive electrode active material layer 22a formed on at least one surface (here, on both surfaces) of the positive electrode substrate 22c.

The positive electrode substrate 22c is formed in a strip-like shape. The positive electrode substrate 22c, for example, consists of an electrically conductive metal, such as aluminum, aluminum alloy, nickel, and stainless steel. The positive electrode substrate 22c herein is a metal foil, in particular, an aluminum foil.

The positive electrode active material layer 22a is, as shown in FIG. 6, provided in a strip-like shape along a longitudinal direction of the positive electrode substrate 22c formed in the strip-like shape. The positive electrode active material layer 22a contains a positive electrode active material that can reversibly store and release a charge carrier. As the positive electrode active material, it is preferable to contain at least one kind among at least Ni, Co, and Mn, and it is possible to use, for example, a lithium-transition metal complex oxide, such as lithium-nickel-cobalt-manganese composite oxide. When a total solid content of the positive electrode active material layer 22a is treated as 100 mass%, the positive electrode active material might occupy approximately 80 mass% or more, typically 90 mass% or more, or, for example, 95 mass% or more. The positive electrode active material layer 22a might contain an arbitrary component other than the positive electrode active material, for example, an electrical conducting material, a binder, various additive components, or the like. As the electrically conducting material, it is possible to use, for example, a carbon material, such as carbon black (for example, acetylene black (AB)). As the binder, it is possible to use, for example, PVdF or the like.

As shown in FIG. 6, the plural positive electrode tabs 22t are configured to protrude from an end part of the electrode assembly 20 in the long side direction Y. In addition, the plural positive electrode tabs 22t are provided at the intervals along a longitudinal direction of the positive electrode 22 formed in a strip-like shape. A shape of the tab herein is a rectangular shape, but it is possible to make it be the other kind of shapes (for example, a trapezoidal shape), or the like. On at least a part of the positive electrode tab 22t, an area is formed where the positive electrode active material layer 22a is not formed and where the positive electrode substrate 22c is exposed.

The negative electrode 24 includes, as shown in FIG. 6, a negative electrode substrate 24c, and the negative electrode active material layer 24a formed on at least one surface (here, on both surfaces) of the negative electrode substrate 24c.

The negative electrode substrate 24c is formed in a strip-like shape. The negative electrode substrate 24c consists of, for example, an electrically conductive metal, such as copper, copper alloy, nickel, and stainless steel. The negative electrode substrate 24c herein is a metal foil, in particular, a copper foil.

The negative electrode active material layer 24a is provided in a strip-like shape along the longitudinal direction of the negative electrode substrate 24c formed in the strip-like shape. The negative electrode active material layer 24a contains a negative electrode active material (for example, a carbon material, such as graphite, and a silicon base material, such as Si and SiO) that can reversibly store and release the charge carrier. When a total solid content of the negative electrode active material layer 24a is treated as 100 mass%, the negative electrode active material might occupy approximately 80 mass% or more, typically 90 mass% or more, or, for example, 95 mass% or more. The negative electrode active material layer 24a might contain an arbitrary component other than the negative electrode active material, for example, a binder, a dispersing agent, various additive components, or the like. As the binder, it is possible to use, for example, rubbers, such as styrene butadiene rubber (SBR). As the dispersing agent, it is possible to use, for example, celluloses, such as carboxymethyl cellulose (CMC).

In a situation where a void rate of the negative electrode active material layer 24a is low (in other words, a high density), a few SEI membranes are generated at the initial electrically charging step, and thus it is possible to calculate a further accurate resistance value at a inspecting resistance step before an electrically charging and discharging step. From a perspective described above, the void rate of the negative electrode active material layer 24a is preferably 20 to 40%, further preferably 22 to 38%, or preferably in particular 25 to 35%.

As shown in FIG. 6, the plural negative electrode tabs 24t are configured to protrude from an end part of the electrode assembly 20 in the long side direction Y. In addition, the plural negative electrode tabs 24t are provided at the intervals along the longitudinal direction of the negative electrode 24 formed in the strip-like shape. A shape of the tab herein is a rectangular shape, but it is possible to make it be the other kind of shapes (for example, a trapezoidal shape), or the like. On at least a part of the negative electrode tab 24t, an area is formed where the negative electrode active material layer 24a is not formed and the negative electrode substrate 24c is exposed.

The separator 26 is a member configured to establish an insulation between the positive electrode active material layer 22a of the positive electrode 22 and the negative electrode active material layer 24a of the negative electrode 24. As the separator 26, it is possible to suitably use, for example, a porous resin sheet consisting of a polyolefin base resin, such as polyethylene (PE) and polypropylene (PP). In addition, the separator 26 might be provided with a heat resistance layer (HRL) on a surface of the above described resin sheet, the HRL containing an inorganic filler. As the inorganic filler, for example, it is possible to use alumina, boehmite, aluminum hydroxide, titania, or the like. In addition, it is preferable to provide an adhesion layer on a surface at one side or surfaces at both sides of the separator 26. The adhesion layer is configured to enhance an adhesive property to the contacting positive electrode active material layer 22a or negative electrode active material layer 24a. The adhesion layer contains, for example, polyvinylidene fluoride (PVdF), as an adhesion component. In addition, the adhesion layer can contain an inorganic particle, such as alumina and boehmite. The adhesion layer might be provided on a surface of the above described resin sheet or might be provided on a surface of the HRL.

### 1.3 Nonaqueous electrolytic solution

The nonaqueous electrolytic solution might be similar to conventional one, and is not particularly restricted. The nonaqueous electrolytic solution contains, for example, a nonaqueous solvent and a supporting salt. The nonaqueous solvent contains, for example, carbonates, such as ethylene carbonate, dimethyl carbonate, and ethyl methyl carbonate. The supporting salt is, for example, a fluorine-containing lithium salt, such as $LiPF_6$.

### 1.4 Battery volume and electric capacity

It is good that a volume and an electric capacity of the nonaqueous electrolyte secondary battery in accordance with the present disclosure are adjusted on the basis of a perspective described below.

An internal resistance of the battery is represented by a sum of a metal part resistance derived from a metal part, such as current collector, and a chemical response resistance derived from a chemical response of a battery element. The secondary battery heats up by Joule heat (Formula 1) which is heat generated when an electric current is made to flow in a conductor having an electric resistance by repeating energization regardless the electrical charge and the electrical discharge. In general, when an absolute value of the metal part resistance and an absolute value of the chemical response resistance are compared, the former is larger. Thus, there is a tendency that a heat generating amount caused by the Joule heat due to the chemical response resistance is larger than a heat generating amount caused by the Joule heat due to the metal part resistance.

$$Q = EIt = (E^2/R)t \quad (\text{Formula 1})$$

Q: Joule heat [J], E: Electric voltage [V], I: Electric current [A], R: Resistance [$\Omega$], t: Time for which the electric current was made to flow [s]

Additionally, although details would be described later, in response to the heat generation of the above described secondary battery, the metal part resistance could be increased, and the chemical response resistance could be reduced. The sum of the metal part resistance and the chemical response resistance after these changes is the internal resistance after the energization. In general, a reduction rate of the chemical response resistance is larger than an increase rate of the metal part resistance due to a temperature increase, and thus there is a tendency that the internal resistance of the secondary battery after the temperature increase is reduced. Further, regarding the above described internal resistance, a rate of the chemical response resistance occupation is inversely proportional to an area size of the electrode assembly. For example, regarding an internal resistance of a small battery in which the area size of the electrode assembly is relatively smaller, the rate of the chemical response resistance tends to become larger in comparison with the metal part resistance. Thus, regarding the small battery in which the rate of the chemical response resistance is large, a change amount of the chemical response resistance caused by the heat generation in response to the electrical charge and the electrical discharge is large, and the internal resistances before and after the electrical charge and the electrical discharge could be significantly fluctuated. In other words, it can be said that it is difficult to reproduce a measurement value of the internal resistance after the electrical charge and the electrical discharge by measuring the internal resistance before the electrical charge and the electrical discharge.

On the other hand, regarding an internal resistance of a large battery, the area size of the electrode assembly is large in comparison with the small battery, and thus the rate of the chemical response resistance with respect to the metal part resistance tends to be small. Therefore, regarding the large battery in which the rate of the chemical response resistance is small, the change amount of the chemical response resistance in response to the electrical charge and the electrical discharge is small, and the internal resistance is not easily fluctuated before and after the electrical charge and the electrical discharge. As described above, it is possible to interpret the measurement of the internal resistance before the electrical charge and the electrical discharge as synonymous with the measurement of the internal resistance after the electrical charge and the electrical discharge. Incidentally, the above described explanation about the action mechanism according to the present technique is estimated, and is not intended to restrict the present technique.

Regarding the secondary battery according to the present disclosure, as described above, from a perspective of precisely calculating the internal resistance, a volume of the above described secondary battery is preferably equal to or more than 500 cm$^3$, further preferably equal to or more than 1,000 cm$^3$, or preferably in particular equal to or more than 1,500 cm$^3$. On the other hand, in a situation where the volume of the secondary battery is too large, there are some fears of taking long time for a room temperature aging step described later, and thus the volume of the secondary battery is preferably equal to or less than 2,500 cm$^3$, further preferably equal to or less than 2,200 cm$^3$, or preferably in particular equal to or less than 2,000 cm$^3$.

Regarding the secondary battery according to the present disclosure, it is easy from the above described perspective to make the secondary battery be larger, and thus it is easy to manufacture the battery having a relatively high capacity. The capacity of the above described secondary battery might be equal to or more than 100 Ah, might be equal to or more than 200 Ah, or might be equal to or more than 300 Ah.

2. Initial electrically charging step

At the initial electrically charging step, the above described secondary battery is electrically charged. At the initial electrical charge on the battery, the electrode active material could decompose an organic matter, such as electrolytic solution component and additive agent, which come into contact at a predetermined electric potential or more. This decomposition product accumulates as a SEI membrane on a surface of the electrode active material. In other words, the SEI membrane is configured with a mix of the decomposition products, such as electrolytic solution component and additive agent. The SEI membrane has no electron conductivity, but it can allow the ion to pass through because it is not a complete continuous membrane. Therefore, the SEI membrane can implement stabilizing and deactivating the electrode active material surface, and then it is possible to suppress an excessive decomposition of the electrolytic solution component, or the like.

Regarding the initial electrically charging step, from a perspective of forming a good SEI membrane, the SOC after the initial electrical charge might be equal to or more than 20%, might be equal to or more than 25%, or might be equal to or more than 30%. On the other hand, in a situation where the SOC after the initial electrical charge is high, it takes long time for the electrical charge so as to cause a delay on the manufacturing step, and thus the SOC after the initial electrical charge is suitably equal to or less than 39%, further suitably equal to or less than 37%, or suitably in particular equal to or less than 35%.

3. High temperature aging step

At a high temperature aging step, the above described secondary battery is heated up and held in a high temperature range. By performing the high temperature aging step, an unnecessary component of the SEI coating layer formed on a surface of the negative electrode at the above described initial electrically charging step is decomposed, and thus the SEI coating layer is modified.

From a perspective of suitably performing the modification of the SEI coating layer, the high temperature range at the high temperature aging step is preferably 40°C to 80°C, further preferably 50°C to 70°C, or preferably in particular 55°C to 65°C. On the other hand, from a perspective of implementing the higher efficiency of the manufacturing step, the holding time at the high temperature aging step is preferably 6 hours to 72 hours, further preferably 12 hours to 48 hours, or preferably in particular 18 hours to 24 hours.

4. Room temperature aging step

At a room temperature aging step, the above described secondary battery is cooled down and held in a room temperature range. The internal resistance of the battery depends on the temperature of the battery, and thus it is difficult to calculate the accurate internal resistance if the battery is in a high temperature state. This is because the chemical response resistance is further reduced as the metal part resistance is increased more and a viscosity of the electrolytic solution becomes lower in response to the increase in a cell temperature and then the movement of the charge carrier (a lithium ion in a situation of the lithium ion secondary battery) is enhanced more. Therefore, in the manufacturing method of the secondary battery according to the present disclosure, the room temperature aging step is provided at which the above described secondary battery is cooled down to and held in the room temperature range after the high temperature aging step. Incidentally, the above described explanation for the action mechanism of the present technique is based on estimation, and is not to restrict the present technique.

From a perspective of suitably decreasing the temperature of the battery after the high temperature aging step, the room temperature range at the room temperature aging step is preferably 15°C to 30°C, further preferably 18°C to 27°C, or preferably in particular 21°C to 24°C. On the other hand, from the perspective of implementing the higher efficiency of the manufacturing step, the holding time at the room temperature aging step is preferably 6 hours to 72 hours, further preferably 12 hours to 48 hours, or preferably in particular 18 hours to 24 hours.

5. Inspecting resistance step

At the inspecting resistance step, the internal resistance of the above described secondary battery is calculated in a state where the above described room temperature range is maintained. When energized regardless the electrical charge and the electrical discharge, the secondary battery heats up according to Joule's law, and then, depending on the heat generating amount due to this, the internal resistance is fluctuated. However, the secondary battery in accordance with the present disclosure is relatively large, then it is not easy to cause the temperature change of the battery before and after the energization, and thus the change amount in the internal resistance is also small. Therefore, if the internal resistance of the secondary battery accompanied by the electrical discharge is calculated, it is possible to precisely calculate the internal resistance.

The manufacturing method of the nonaqueous electrolyte secondary battery according to the present disclosure performs the electrical charge to a relatively low SOC at the initial electrically charging step, in order to shorten the manufacturing step as described above. Further, the process of electrically charging to the low SOC and then ending the initial electrically charging step brings a benefit on enhancing the precision of later measuring the internal resistance, too. In a situation where the SOC is relatively low and is within a predetermined range, the positive electrode does not easily absorb the lithium ion at the electrically discharging time, thus the chemical response resistance is increased, and then the internal resistance is also increased. As the result, a resistance difference is significantly appeared, and then it is possible to precisely measure the internal resistance. In the manufacturing method of the nonaqueous electrolyte secondary battery according to the present disclosure, by intentionally selecting the SOC area as described above, it is possible to achieve both implementing the higher efficiency of the manufacturing step and enhancing the measurement precision for the internal resistance.

Incidentally, in the manufacturing method of the nonaqueous electrolyte secondary battery according to the present disclosure, a SOC adjustment for the above described internal resistance calculation is performed at the initial electrically charging step, and thus a step for re-adjusting the SOC at the internal resistance calculation time is not included. By this, the unnecessary SOC adjusting step can be omitted, and thus it is possible not only to implement the higher efficiency for the manufacturing step but also to enhance the measurement precision for the internal resistance.

6. Electrically charging and discharging step

At the electrically charging and discharging step, the electrical charge and the electrical discharge are performed on the above described secondary battery after the above described resistance inspection. In other words, in the manufacturing method of the nonaqueous electrolyte secondary battery according to the present disclosure, it can be said that the above described inspecting resistance step is performed before this electrically charging and discharging step.

<<Evaluation>>

1. Test example

Below, a test example relating to the herein disclosed technique would be explained, but it is not intended to restrict the herein disclosed technique to the test example.

(1) Practical example 1

A lithium-nickel-cobalt-manganese base composite oxide (NCM) as the positive electrode active material, polyvinylidene fluoride (PVdF) as the binder, and a carbon nanotube (CNT) as the electrically conducting material were weighed to satisfy a mass ratio being NCM : PVdF : CNT = 97.5 : 1.5 : 1, and were mixed in N-methyl-2-pyrrolidone (NMP), so that a positive electrode slurry was prepared. This positive electrode slurry was applied to coat both surfaces of the positive electrode substrate (an aluminum foil, thickness 12 $\mu$m) formed in a long strip-like shape, and then dried. This was cut to have a predetermined size and was extended by a rolling press, so that the positive electrode sheet was obtained in which the positive electrode active material layer on both surfaces of the positive electrode substrate, while a thickness of the positive electrode active material layer was 150 $\mu$m.

Next, a natural graphite (C) as the negative electrode active material, a styrene butadiene rubber (SBR) as the binder, and carboxymethyl cellulose (CMC) as the thickening agent were weighed to satisfy a mass ratio being C : SBR : CMC = 98.5 : 1 : 0.5, and were mixed in water, so that the negative electrode slurry was prepared. This negative electrode slurry was applied to coat both surfaces of the negative electrode substrate (a copper foil, 9 $\mu$m) formed in a long strip-like shape, and then dried. By this step, the negative electrode active material layer was formed on the negative electrode substrate, and then it was extended by the rolling press, so that the negative electrode sheet was obtained in which the negative electrode active material layer is provided, while a total thickness of the negative electrode active material layer was 180 $\mu$m.

Then, the separator was prepared which had a three layers structure consisting of PE/PP/PE and whose thickness was 14 $\mu$m, and then the positive electrode sheet, the separator, and the negative electrode sheet were stacked in this order. The electrode terminal was attached to the electrode assembly manufactured as described above, and then the resultant was accommodated in a battery case together with the nonaqueous electrolytic solution, so that the cell was manufactured. The terminal was connected to the electrode of this cell, and a preliminary charge was performed by 0.6 C until the charge rate reached SOC 25%.

As the nonaqueous electrolytic solution, a solution was used in which $LiPF_6$ was dissolved as the supporting salt at a concentration being 1.15 mol/L into a mixed solvent containing ethylene carbonate (EC), dimethyl carbonate (DMC), and ethyl methyl carbonate (EMC) at a volume ratio being EC : DMC : EMC = 3 : 3 : 4.

(1) Practical example 1

A secondary battery whose capacity was 200 Ah was subjected to the constant current charge by 100 A (0.5 C) until an electrical charge capacity reached the SOC 25% as shown in FIG. 1. Next, a high temperature aging process was performed under 60°C environment for 6 hours, and then a room temperature aging process was performed under 25°C environment for 8 hours. After the room temperature aging process ended, the electrical discharge was performed by a discharge electric current 100 A (0.5 C) for 10 seconds, the electric voltages before and after the electrical discharge were respectively treated as $V_1$ and $V_2$, a discharge electric current was treated as A, and then the internal resistance of the above described secondary battery before the electrically charging and discharging step (the internal resistance I) was calculated with Formula (1) described below.

$$\text{Internal resistance} = (V_1\text{-}V_2)/A \quad (1)$$

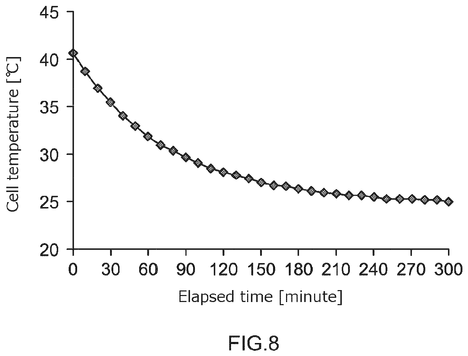

After the above described internal resistance I was calculated, the electrically charging and discharging step was performed at which, in particular, the constant current charge was performed by 100 A (0.5 C) until the charge rate reached SOC 100% (4.3 V), and then the constant current discharge was performed by 100 A until it reached SOC 25% (3.6 V). Then, with the above described Formula (1), the internal resistance after the electrically charging and discharging step (the internal resistance II) was calculated, and then it was compared with a value of the internal resistance I measured before the electrically charging and discharging step. Incidentally, a battery temperature was 41°C when the above described electrically charging and discharging step ended, and it took about 4 hours as shown in FIG. 8 in order to cool down to the temperature 25°C at which the internal resistance II was measured.

(2) Practical example 2

Manufacture of the secondary battery and the test were performed similarly to Practical example 1, other than a matter that the electrical charge capacities before and after the electrically charging and discharging step were different.

(3) Comparative example 1

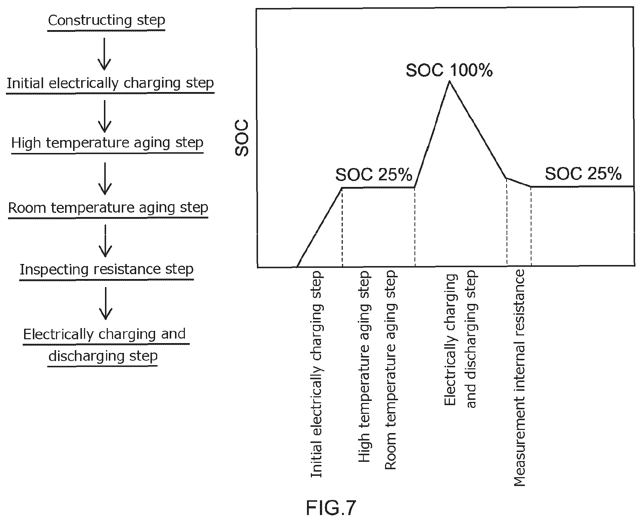

The secondary battery whose capacity was 200 Ah was manufactured, similarly to Practical example 1. As shown in FIG. 7, the constant current charge was performed by 100 A (0.5 C) until the charge rate reached the SOC 25%. Next, the high temperature aging process was performed under 60°C environment for 6 hours, and then the room temperature aging process was performed under 25°C environment for 8 hours. After that, as the electrically charging and discharging step, the constant current charge was performed by 100 A (0.5 C) until the charge rate reached the SOC 100%, and then the constant current discharge was performed by 100 A (0.5 C) until the charge rate reached the SOC 25%. After the electrically charging and discharging step, the secondary battery was cooled down until the temperature of the secondary battery was decreased to be 25°C and the internal resistance II was derived similarly to Practical example 1. In other words, regarding Comparative example 1, the manufacture of the secondary battery and the test were performed similarly to Practical example 1, other than a matter that the internal resistance I was not measured but only the internal resistance II was measured after the electrically charging and discharging step. Incidentally, the cooling step after the electrically charging and discharging step took about 4 hours as shown in FIG. 8.

(4) Comparative example 2

The secondary battery whose capacity was 5 Ah was manufactured, similarly to Practical example 1. As shown in FIG. 7, the constant current charge was performed by 2.5 A (0.5 C) until the charge rate reached the SOC 25%. Next, the high temperature aging process was performed under 60°C environment for 6 hours, and then the room temperature aging process was performed under 25°C environment for 8 hours. After that, as the electrically charging and discharging step, the constant current charge was performed by 2.5 A (0.5 C) until the charge rate reached the SOC 100% and then the constant current discharge was performed by 2.5 A (0.5 C) until the charge rate reached 25%. After the electrically charging and discharging step, the electrical discharge was performed by the discharge electric current 2.5 A (0.5 C) for 10 seconds in a state where the temperature of the secondary battery was 25°C, the electric voltages before and after the electrical discharge were respectively treated as $V_1$ and $V_2$, the discharge electric current was treated as A, and the internal resistance II of the secondary battery was calculated with the above Formula (1). Incidentally, the temperature of the secondary battery after the electrically charging and discharging step was approximately 25°C, and an intentional cooling step was not performed when the internal resistance II was measured. In other words, regarding Comparative example 2, the manufacture of the secondary battery and the test were performed similarly to Comparative example 1, other than the battery capacity and a matter that the cooling step was not performed after the electrically charging and discharging step.

[Table 1]

Table 1

| | | Practical example 1 | Practical example 2 | Comparative example 1 | Comparative example 2 |
|---|---|---|---|---|---|
| Capacity [Ah] | | 200 | 200 | 200 | 5 |
| SOC after initial electrically charging step [%] | | 25 | 20 | 25 | 25 |
| Internal resistance measurement | Measuring time | Before and after electrically charging and discharging step | Before and after electrically charging and discharging step | After electrically charging and discharging step | After electrically charging and discharging step |
| | Measurement value I [mΩ] | 0.5 | 0.5 | - | - |
| | Cooling time [h] | 4 | 4 | 4 | 0 |
| | Measurement value II [mΩ] | 0.5 | 0.5 | 0.5 | 0.5 |

2. Evaluation result

Based on the result described above, regarding Practical examples 1 and 2, each of the internal resistances I and II before and after the electrically charging and discharging step was 0.5 mΩ, and a value of the internal resistance after the electrically charging and discharging step could be reproduced by measuring the internal resistance before the electrically charging and discharging step. In other words, it is possible to interpret the measurement of the internal resistance before the electrically charging and discharging step and the measurement of the internal resistance after the electrically charging and discharging step as synonymous with each other.

Regarding Comparative example 1, in comparison with Practical example 1, a timing for measuring the internal resistance was different, and it was performed only after the electrically charging and discharging step. The temperature of the secondary battery after the electrically charging and discharging step was 41°C, and it took about 4 hours for cooling down to 25°C at which the measurement of the internal resistance II was performed.

In comparison with Comparative example 1, regarding Comparative example 2, the battery capacity was different, and it was a battery whose surface area size with respect to the battery capacity was relatively large. The temperature of the secondary battery after the electrically charging and discharging step was 25°C, the cooling step for relieving the cell temperature increase due to the Joule heat generated by the electrical charge and the electrical discharge was unnecessary. This seems to have occurred, as the surface area size of the secondary battery with respect to the battery capacity was large, due to implementing an efficient heat dissipation during the electrical charge and the electrical discharge.

Based on the above described result, it was confirmed that the time for the manufacturing step could be shorten by measuring the internal resistance of the secondary battery, in which the area size of the electrode assembly was relatively large, after the end of the room temperature aging step and before the electrically charging and discharging step, because the cooling step was unnecessary for relieving the temperature increase of the secondary battery due to the Joule heat generated in response to the electrical charge and the electrical discharge. Incidentally, in the secondary battery like Comparative example 2 whose surface area size is relatively large with respect to the battery capacity, it is possible to efficiently perform the heat dissipation on the secondary battery that heats up due to the electrical charge and the electrical discharge, thus there is no problem even if the internal resistance is measured after the electrically charging and discharging step, and therefore it is outside the scope of the technical concept in accordance with the present disclosure.

In the above described embodiment, the manufacturing method of the nonaqueous electrolyte secondary battery includes an constructing step for constructing the secondary battery whose volume is equal to or more than at least 500 cm$^3$, an initial electrically charging step for electrically charging the secondary battery until a SOC becomes 20% to 39%, a high temperature aging step for heating up and holding the secondary battery in a high temperature range, a room temperature aging step for cooling down the secondary battery being in the high temperature range and then holding the secondary battery in a room temperature range, and an inspecting resistance step for measuring an internal resistance of the secondary battery while the secondary battery is maintained in the room temperature range.

In the manufacturing method of the nonaqueous electrolyte secondary battery described above, the secondary battery is relatively large, and the SOC after the initial electrical charge is a predetermined value being relatively low. Thus, it is less susceptible to the effect of the Joule heat before and after the energization, and thus it is possible to precisely calculate the internal resistance. In addition, by shortening the electrically charging time and the electrically discharging time when the internal resistance is measured, it is possible to enhance the efficiency of the manufacturing step.

In the above described embodiment, the internal resistance is measured before the electrically charging and discharging step. By this, it is not affected by the heat generation caused by the Joule heat generated at the electrically charging and discharging step, and thus it is possible to precisely calculate the internal resistance.

In the above described embodiment, the volume of the secondary battery is relatively large, the rate occupied by the metal part resistance of the internal resistance is relatively large, and thus the heat generating amount caused by the Joule heat in response to the energization is small. By this, it is possible to calculate the internal resistance at the higher precision and to perform the energization for a short time at the internal resistance calculation time, so as to suitably enhance the efficiency of the manufacturing step.

In the above described embodiment, the SOC after the initial electrically charging step is relatively low, and thus it is possible to enhance the efficiency of the manufacturing step. In addition, the SEI coating layer generated after the initial electrically charging step is relatively a few, and thus it is possible to suitably enhance a precision of the internal resistance calculation.

In the above described embodiment, it is possible to suitably implement manufacturing the large battery whose volume is relatively large. By this, it is possible to suitably implement the higher capacity of the secondary battery.

In the above described embodiment, the SOC after the initial electrically charging step is adjusted to be a predetermined value. By this, it is possible to suppress the reduction in the measurement precision of the internal resistance of the secondary battery due to the Joule heat, and to implement enhancing the efficiency of the manufacturing step by shortening the electrically charging time.

In the above described embodiment, by adjusting the temperature at which the aging step is performed, it is possible to suitably modify the SEI coating layer formed after the initial electrically charging step.

In the above described embodiment, by adjusting the temperature at which the room temperature aging step, it is possible to suitably cool down the secondary battery after the high temperature aging and to precisely measure the internal resistance.

In the above described embodiment, by adjusting the time taken for performing the high temperature aging step, it is possible to suitably modify the SEI coating layer formed after the above described initial electrically charging step.

In the above described embodiment, by adjusting the time taken for performing the room temperature aging step, it is possible to suitably cool down the secondary battery after the high temperature aging step and to precisely measure the internal resistance.

Above, the herein disclosed technique has been variously explained. Unless specifically mentioned, the embodiment described herein is not to restrict the present disclosure. In addition, the herein disclosed technique can be variously changed, and each configuration element and each process described herein can be suitably omitted or suitably combined insofar as there are no special issues. In addition, the present specification includes disclosures recited by each item described below.

Item 1:

A manufacturing method of a nonaqueous electrolyte secondary battery, comprising:

a constructing step for constructing a secondary battery whose volume is equal to or more than at least 500 cm$^3$;
an initial electrically charging step for electrically charging the secondary battery until a SOC becomes 20% to 39%;
a high temperature aging step for heating up and holding the secondary battery in a high temperature range;
a room temperature aging step for cooling down the secondary battery being in the high temperature range and then holding the secondary battery in a room temperature range; and
an inspecting resistance step for measuring an internal resistance of the secondary battery while the secondary battery is maintained in the room temperature range.

Item 2:

The manufacturing method of the nonaqueous electrolyte secondary battery recited in Item 1, further comprising:
a step for electrically charging and electrically discharging a secondary battery after the inspecting resistance step.

Item 3:

The manufacturing method of the nonaqueous electrolyte secondary battery recited in Item 1 or 2, wherein the volume of the secondary battery is 500 cm$^3$ to 2500 cm$^3$.

Item 4:

The manufacturing method of the nonaqueous electrolyte secondary battery recited in any one of Items 1 to 3, wherein
a void rate of a negative electrode active material layer is 20% to 40%.

Item 5:

The manufacturing method of the nonaqueous electrolyte secondary battery recited in any one of Items 1 to 4, wherein
an electric capacity of the secondary battery is equal to or more than 100 Ah.

Item 6:

The manufacturing method of the nonaqueous electrolyte secondary battery recited in any one of Items 1 to 5, wherein
the initial electrically charging step electrically charges to have the SOC being 20% to 100%.

Item 7:

The manufacturing method of the nonaqueous electrolyte secondary battery recited in any one of Items 1 to 6, wherein
the high temperature range is 40°C to 80°C.

Item 8:

The manufacturing method of the nonaqueous electrolyte secondary battery recited in any one of Items 1 to 7, wherein

the room temperature range is 15°C to 30°C.

Item 9:

The manufacturing method of the nonaqueous electrolyte secondary battery recited in any one of Items 1 to 8, wherein

a holding time of the high temperature aging step is 6 hours to 72 hours.

Item 10:

The manufacturing method of the nonaqueous electrolyte secondary battery recited in any one of Items 1 to 9, wherein

a holding time of the room temperature aging step is 6 hours to 72 hours.

[Reference Signs List]

    10 Battery case
    12 Outer package
    14 Sealing plate
    20 Electrode assembly group
    20a, 20b, 20c Electrode assembly
    22 Positive electrode
    22a Positive electrode active material layer
    22c Positive electrode substrate
    22t Positive electrode tab
    24 Negative electrode
    24a Negative electrode active material layer
    24c Negative electrode substrate
    24t Negative electrode tab
    26 Separator
    30 Positive electrode terminal
    40 Negative electrode terminal
    50 Positive electrode current collector part
    60 Negative electrode current collector part
    100 Nonaqueous electrolyte secondary battery

**Claims**

1. A manufacturing method of a nonaqueous electrolyte secondary battery (100), comprising:

   a constructing step for constructing a secondary battery (100) whose volume is equal to or more than at least 500 cm$^3$;
   an initial electrically charging step for electrically charging the secondary battery (100) until a SOC becomes 20% to 39%;
   a high temperature aging step for heating up and holding the secondary battery (100) in a high temperature range;
   a room temperature aging step for cooling down the secondary battery (100) being in the high temperature range and then holding the secondary battery (100) in a room temperature range; and
   an inspecting resistance step for measuring an internal resistance of the secondary battery (100) while the secondary battery (100) is maintained in the room temperature range.

2. The manufacturing method of the nonaqueous electrolyte secondary battery (100) according to claim 1, further comprising:
a step for electrically charging and electrically discharging the secondary battery (100) after the inspecting resistance step.

3. The manufacturing method of the nonaqueous electrolyte secondary battery (100) according to claim 1 or 2, wherein the volume of the secondary battery (100) is 500 cm$^3$ to 2500 cm$^3$.

4. The manufacturing method of the nonaqueous electrolyte secondary battery (100) according to any one of claim 1 to 3, wherein
a void rate of a negative electrode active material layer (24a) is 20% to 40%.

5. The manufacturing method of the nonaqueous electrolyte secondary battery (100) according to any one of claim 1 to 4, wherein
an electric capacity of the secondary battery (100) is equal to or more than 100 Ah.

6. The manufacturing method of the nonaqueous electrolyte secondary battery (100) according to any one of claim 1 to 5, wherein
the initial electrically charging step electrically charges to have the SOC being 20% to 100%.

7. The manufacturing method of the nonaqueous electrolyte secondary battery (100) according to any one of claim 1 to 6, wherein
the high temperature range is 40°C to 80°C.

8. The manufacturing method of the nonaqueous electrolyte secondary battery (100) according to any one of claim 1 to 7, wherein
the room temperature range is 15°C to 30°C.

9. The manufacturing method of the nonaqueous electrolyte secondary battery (100) according to any one of claim 1 to 8, wherein
a holding time of the high temperature aging step is 6 hours to 72 hours.

10. The manufacturing method of the nonaqueous electrolyte secondary battery (100) according to any one of claim 1 to 9, wherein
a holding time of the room temperature aging step is 6 hours to 72 hours.

Constructing step

↓

Initial electrically charging step

↓

High temperature aging step

↓

Room temperature aging step

↓

Inspecting resistance step

↓

Electrically charging and
discharging step

FIG.1

FIG.2

FIG.3

FIG.4

FIG.5

FIG.6

Constructing step

↓

Initial electrically charging step

↓

High temperature aging step

↓

Room temperature aging step

↓

Inspecting resistance step

↓

Electrically charging and discharging step

SOC

SOC 100%

SOC 25%

SOC 25%

Initial electrically charging step

High temperature aging step

Room temperature aging step

Electrically charging and discharging step

Measurement internal resistance

FIG.7

FIG.8

| | Europäisches Patentamt |
|---|---|
| | European Patent Office |
| | Office européen des brevets |

# EUROPEAN SEARCH REPORT

**Application Number**

EP 25 18 9896

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 114 005 956 B (TIANJIN LISHEN BATTERY JOINT STOCK CO LTD) 10 May 2022 (2022-05-10) | 1,3-10 | INV. H01M10/052 H01M10/058 |
| A | * paragraphs [0031], [0055] * | 2 | H01M10/48 H01M10/44 |
| A | CN 116 190 661 A (JIANGSU TIANHE ENERGY STORAGE CO LTD) 30 May 2023 (2023-05-30) * paragraphs [0042] - [0044] * | 1-10 | ADD. H01M4/02 |

**TECHNICAL FIELDS SEARCHED (IPC)**

H01M

The present search report has been drawn up for all claims

| Place of search | Date of completion of the search | Examiner |
|---|---|---|
| Munich | 4 December 2025 | Gregori, Giuliano |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 18 9896

This annex lists the patent family members relating to the patent documents cited in the above-mentioned European search report.
The members are as contained in the European Patent Office EDP file on
The European Patent Office is in no way liable for these particulars which are merely given for the purpose of information.

04-12-2025

| Patent document cited in search report | | Publication date | Patent family member(s) | Publication date |
|---|---|---|---|---|
| CN 114005956 | B | 10-05-2022 | NONE | |
| CN 116190661 | A | 30-05-2023 | NONE | |

EPO FORM P0459

For more details about this annex : see Official Journal of the European Patent Office, No. 12/82

**EP 4 708 425 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2014225368 A

- JP 2013152849 A